# EUROPÄISCHE PATENTSCHRIFT

(11) **EP 0 421 018 B1**
(45) Veröffentlichungstag und Bekanntmachung des Hinweises auf die Patenterteilung: **16.03.1994**
(21) Anmeldenummer: 89118618.1
(22) Anmeldetag: 06.10.1989
(51) Int. Cl.: B23K 20/10, H01R 43/12

(54) **Verfahren und Vorrichtung zum Schweissen von metallischen Werkstücken durch Ultraschall**
Method and device for welding of metallic work-pieces with ultrasonic waves
Méthode et dispositif de soudage de pièces métalliques par ultrasons

(43) Veröffentlichungstag der Anmeldung: 10.04.1991
(73) Patentinhaber: SIEMENS AKTIENGESELLSCHAFT, 80333 München (DE)
(72) Erfinder: Krause, Ralf-Dieter, Dipl.-Ing., D-8500 Nürnberg 30 (DE); Moll, Helmut, Dipl.-Ing.(FH), D-8520 Erlangen (DE)

(56) Entgegenhaltungen:
- FR-A- 2 302 172
- US-A- 4 631 685
- WELDING JOURNAL vol. 57, no. 2, Februar 1978, Miami,FL,US Seiten 19 - 25;HULST: "Ultrasonic bonding of insulated wire"

## Beschreibung

Die Erfindung bezieht sich auf ein Verfahren zum Anschweißen von lackisolierten Drähten und/oder Litzen auf metallische Träger durch Ultraschall, bei dem über eine Sonotrode durch Kraftbeaufschlagung einerseits und Ultraschalleinwirkung andererseits eine stoffschlüssige Verbindung durch über die Schweißzeit vorgegebene Materialverformung wenigstens der Drähte und/oder Litzen entsprechend einer vorbestimmbaren Absenkgeschwindigkeit erreicht wird, wobei die Absenkgeschwindigkeit regel- oder programmierbar ist. Daneben bezieht sich die Erfindung auf die zugehörige eine zur Durchführung des Verfahrens vorgsehene Vorrichtung mit einem Antriebssystem einer Ultraschall-Schweißpresse, die aus einer von einem Generator aktivierbaren, absenkbaren Sonotrode und einem feststehenden Amboß zur Aufnahme der metallischen Werkstücke besteht, wobei das Antriebssystem ein regel- oder programmierbarer Motorantrieb ist.

Speziell beim Ultraschall-Metallschweißen, das im Fertigungsbetrieb eine immer größere Rolle einnimmt, ist die Qualität zu optimieren und sind insbesondere die Prozeßzeiten für den einzelnen Fertigungsschritt zu minimieren. Insbesondere gilt dies für das Anschweißen von Drähten auf großflächige metallische Träger.

Beim Ultraschall-Metallschweißen wird durch den Einfluß der Schwingungsamplitude und der Schweißkraft vor allem das der Sonotrode zugewandte Fügeteil deformiert. Ist einerseits die Verformung zu gering, lösen sich die beiden Fügeteile mit geringem Kraftaufwand; bei zu großer Verformung brechen dagegen andererseits die Teile am Übergang der Verformung zum unverformten Querschnitt.

Neben der Verformung hat beim Ultraschall-Metallschweißen auch die Schweißzeit und insbesondere die Einwirkzeit des Ultraschalls zur Beseitigung der Oxide und Verunreinigungen im Fügebereich einen qualitätsbestimmenden Einfluß. Speziell bei dünnen Metalldrähten spielt die Oberflächenbeschaffenheit und eine Beschichtung des Drahtes mit Kunststoff- oder Lackisolierungen eine große Rolle.

Insbesondere lackisolierte Drähte mit Durchmessern unter 100 µm sind in der Praxis mittels Ultraschall schwierig zu schweißen. In der US-A-38 22 465 (≙ "Welding Journal", Vol. 57 (1978), Seiten 19 bis 25; die US-A-38 22 465 offenbart ein Verfahren gemäß dem Oberbegriff des Anspruchs 1) wird angegeben, daß derartige Drähte nur dann erfolgreich durch Ultraschall auf metallische Unterlagen aufgeschweißt werden können, wenn der Schweißzyklus aus einem Vorimpuls zum Entfernen der Isolierung und dem eigentlichen Schweißimpuls zum Herstellen der metallischen Verbindung besteht. Es wird dort also in Teilschritten mit variierenden Anpreßkräften und Ultraschallamplituden gearbeitet, was jedoch nicht ohne weiteres in einer automatischen Fertigung für die Massenproduktion einsetzbar ist.

Bei den Ultraschall-Schweißanlagen der Praxis wird im allgemeinen die Schweißkraft pneumatisch aufgebracht und die Absenkgeschwindigkeit der Sonotrode durch pneumatische Drosseln bzw. durch Auffahren auf einen hydraulischen Dämpfungszylinder vorgewählt. Die Arbeitsgeschwindigkeit der Sonotrode kann nur indirekt durch die Größen Schweißkraft, Drossel- bzw. Dämpferstellung und Wahl der Ultraschallamplitude beeinflußt werden. Unkontrollierbare Schwankungen der Arbeitsgeschwindigkeit und der Schweißkraft bewirken aber Qualitätsschwankungen der Schweißverbindung.

Beim Stand der Technik werden die Einflußgrößen Schweißkraft und Schweißzeit und die daraus resultierende Verformung empirisch als Grundlage für den Fertigungsprozeß ermittelt. Dies setzt aber im wesentlichen eine Konstanz der übrigen Einflußgrößen voraus, was nicht immer gewährleistet ist: Bei einer Veränderung der Ankopplung von Sonotrode zum Fügeteil bzw. vom Fügeteil zum Amboß, oder einer Veränderung der Oberflächenbeschaffenheit im Fügebereich, bei Änderungen der Schweißkraft, Kraftaufbau, Absenkgeschwindigkeit der Sonotrode treten erfahrungsgemäß Schwankungen der Schweißqualität auf. Als geeignete Qualitätssicherung werden deswegen beispielsweise die Überwachung der Schweißleistung bzw. der Schweißenergie und des Verformungsweges herangezogen. Im übrigen müssen nach wie vor Stichproben durchgeführt werden.

Aus der FR-A-23 02 172 (die eine Vorrichtung mit den im Oberbegriff des Anspruchs 4 angegebenen Merkmalen offenbart) ist eine Vorrichtung zum Ultraschallschweißen mit einer absenkbaren Sonotrode bekannt, bei der die Sonotrode mit einem Motor über eine Untersetzung und zugehörigem Antriebsrad mit daran eingreifender Zahnstange verbunden ist, und bei der Mittel zur Erfassung der Absenkgeschwindigkeit der Sonotrode vorhanden sind. Damit soll insbesondere die Dauer der Ultraschalleinwirkung regeltechnisch mit der Bewegung des Schweißkopfes verknüpft werden, wozu eine elektrische Spannung in Abhängigkeit von der Verschiebegeschwindigkeit der Sonotrode erzeugt wird. Davon abgesehen wird auf Seite 5, Zeilen 13 bis 15 der FR-A-23 02 172 erwähnt, daß eventuell vorgesehen werden kann, die Absenkgeschwindigkeit der Sonotrode in Abhängigkeit von erzielten Ergebnissen zu programmieren. Konkrete technische Angaben sind allerdings nicht vorhanden.

Weiterhin ist aus der SU-A-721 286 eine Einrichtung zur Erfassung der Verformung beim automatischen Ultraschall-Mikroschweißen bekannt, bei dem das Schließen des Auslösekontaktes über eine vorbestimmte Anzahl von Motorschritten es ermöglicht, die notwendige Verformung zu erreichen. Damit soll insbesondere die Qualität der Schweißverbindungen in der Massenfertigung in Abhängigkeit von der Werkstückform, Größe und Oberflächenbeschaffenheit gewährleistet werden.

Schließlich ist aus der DE-A-37 23 333 ein Verfahren zur Steuerung von Ultraschall-Schweißmaschinen bei der Verschweißung von Werkstücken über eine druckmittelbeaufschlagbare Vorschubeinheit mit Sonotrode bekannt, bei dem der Andruck der Sonotrode durch zeit-und/oder vorschubwegabhängige Veränderungen des Drucks in dem die Vorschubeinheit beaufschlagendem Druckmittel entsprechend dem materialbedingten Schweißverhalten der zu verschweißenden Werkstücke gesteuert wird.

Aufgabe der Erfindung ist es demgegenüber, ein Verfahren für das Anschweißen von lackisolierten und/oder Litzen anzugeben, bei dem eine Qualitätssicherung in einfacher Weise bewerkstelligt ist. Dazu soll die zugehörige Vorrichtung bereitgestellt werden.

Die Aufgabe ist bei einem Verfahren der eingangs genannten Art erfindungsgemäß dadurch gelöst, daß die Parameter für die Einstellung bzw. Regelung der Absenkgeschwindigkeit der Sonotrode die Abmessungen und/oder die Ausbildung der Oberflächen der Drähte und/oder Litzen bzw. deren Beschichtung sind, wobei die Absenkgeschwindigkeit der Sonotrode während der Materialverformung entweder konstant vorgegeben ist oder deren Änderung von niedrigeren zu höheren Werten vorprogrammiert wird.

Bei der zur Durchführung des angegebenen Verfahrens vorgesehenen Vorrichtung ist dem Generator für die Sonotrode ein Steuergerät nachgeschaltet, mit dem gleichermaßen die zeitliche Ultraschallaktivierung der Sonotrode und die Regelung bzw. Programmierung des Motorantriebes erfolgt, und sind Mittel zur Einstellung bzw. Regelung der Absenkgeschwindigkeit der Sonotrode entsprechend den Abmessungen und/oder der Ausbildung der Oberflächen der Drähte und/oder der Litzen bzw. deren Beschichtung vorhanden, welche Mittel die Absenkgeschwindigkeit während der Materialverformung entweder konstant vorgeben oder deren Änderung von niedrigen zu höheren Werten vorprammieren. Vorzugsweise besteht der programmierbare Motorantrieb einer solchen Vorrichtung aus einem Drehstrommotor mit Tachogenerator. Weiterhin kann die Schweißpresse vorteilhafterweise einen Wegaufnehmer und/oder einen Kraftsensor als Signalgeber für die Regelung enthalten. In jedem Fall sind die Mittel zur Steuerung bzw. Programmierung der Absenkgeschwindigkeit der Sonotrode derart ausgebildet, daß die Geschwindigkeit der Zustellbewegung der Sonotrode und deren Arbeitsgeschwindigkeit beim Schweißen separat vorgebbar sind.

Weitere Einzelheiten und Vorteile der Erfindung ergeben sich aus der nachfolgenden Figurenbeschreibung von Ausführungsbeispielen anhand der Zeichnung. Es zeigen in schematischer Darstellung
FIG 1 und FIG 2 Ultraschallwerkzeuge zum Aufschweißen von Drähten auf metallische Träger in Vorder- und Seitenansicht,
FIG 3 im Querschnitt einen unzulänglich aufgeschweißten Draht mit Isolierung,
FIG 4 und FIG 5 einen erfindungsgemäß angeschweißten Draht im Querschnitt und Längsdarstellung,
FIG 6 eine dabei verwendete Schweißpresse mit programmierbarem Motorantrieb sowie die
FIG 7, FIG 8 und FIG 9 Schweißgrößen-Zeit-Diagramme beim vorgeschlagenen Prozeßablauf.

Beim Ultraschallschweißen von Drähten oder Litzen auf metallische Träger werden die Drähte oder die Litzen durch Kraftbeaufschlagung unter gleichzeitiger Ultraschalleinwirkung verformt. Insbesondere bewirken zunächst die Ultraschallschwingungen eine Beseitigung von Oberflächenverunreinigungen an den Werkstücken und speziell bei isolierten Drähten eine Entfernung der Isolierung, wonach anschließend durch den ultraschallaktivierten Reibvorgang eine stoffschlüssige Verbindung der metallischen Drähte oder Litzen mit dem Träger erreicht wird.

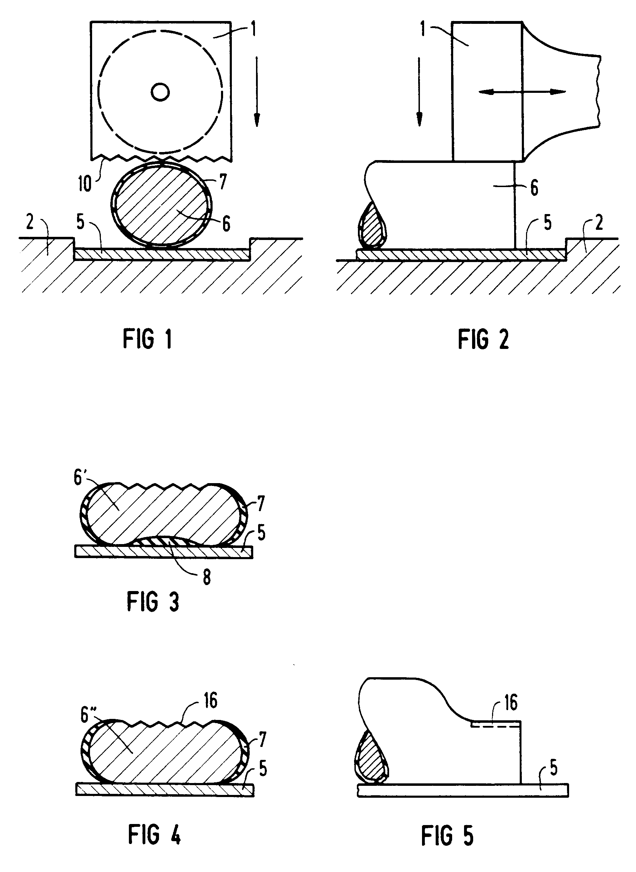

In FIG 1 ist für obigen Zweck eine Ultraschall-Sonotrode 1 vorhanden, die in horizontaler Richtung mit einer Frequenz von beispielsweise 20 kHz schwingt und nach einer Absenkbewegung bis auf die Werkstücke beispielsweise mit einer Kraft von beispielsweise 50 N auf die im Amboß 2 fixierten Werkstücke drückt. Letztere bestehen gemäß FIG 1 aus einem metallischen Träger 5 und einem Draht 6, beispielsweise der Dicke von 100 µm, der mit einer Isolationsschicht 7 umgeben ist. Die Sonotrode 1 kann an ihrer Arbeitsfläche eine Struktur 10, insbesondere nach Art eines sogenannten Waffelmusters, haben.

Da bei dünner werdenden Drähten das Verhältnis von Drahtdurchmesser zur Beschichtungsstärke immer ungünstiger und damit die zu verformenden Volumina immer geringer werden, bekommt der korrekte Prozeßablauf zunehmende Bedeutung. Wird beispielsweise der Draht bei erfolgter Ultraschalleinwirkung zu schnell verformt, kann ein Querschnitt gemäß FIG 3 entstehen: Die untere Fügefläche ist hier vor der eigentlichen Verschweißung nicht hinreichend vom Kunststoff befreit. Dieser sammelt sich im Mittenbereich an, wonach das Verschweißen der metallischen Fügeflächen nur seitlich davon erfolgt. Eine solche Schweißverbindung hat weder eine hinreichende mechanische Festigkeit, noch speziell bei elektrischen Leitungen den geforderten niedrigen Übergangswiderstand.

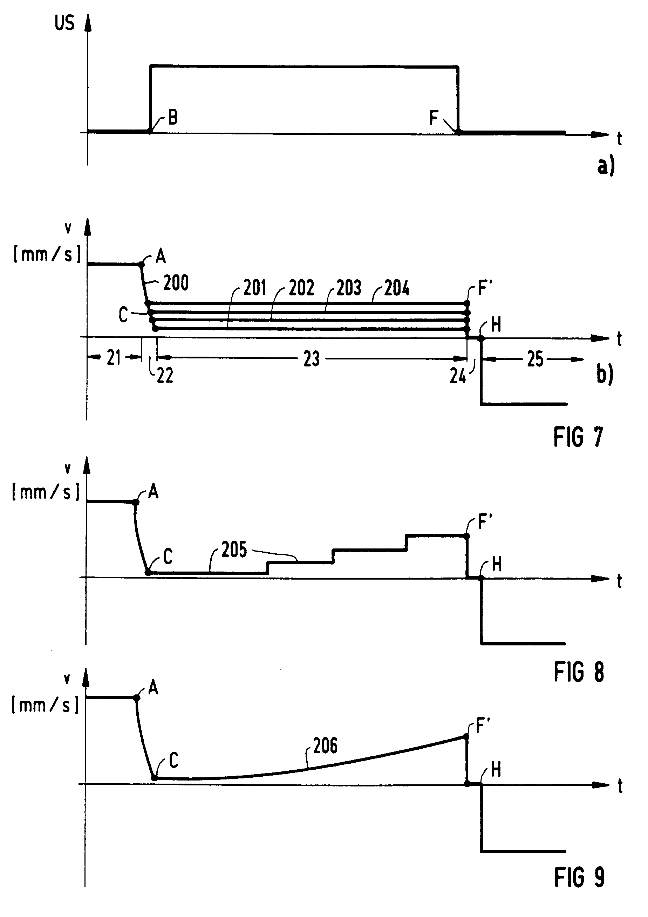

In FIG 4 und FIG 5 ist ein auf eine Unterlage 5 korrekt angeschweißter Draht 6 dargestellt. Zum Erreichen einer solchen stoffschlüssigen Verbindung beginnt nach dem Aufsetzen der Sonotrode 1 mit Arbeitsfläche 10 auf die Beschichtung 7 des Drahtes 6 ein spezifischer Prozeßverlauf, der anhand der FIG 7 bis 9 weiter unten im einzelnen erläutert wird. Ergebnis der Schweißung ist eine gleichmäßige stoffschlüssige Verbindung des Drahtes 6 mit dem Träger 5, bei dem das Isolationsmaterial nach außen weggedrückt ist und eine Verschweißung der metallischen Materialien an ihrer gesamten Berührungsfläche erfolgt ist. Die Oberfläche hat nach Fertigstellung der Schweißverbindung eine Struktur 16 entsprechend der Struktur 10 der Sonotrode 1.

Durch ein geeignetes Antriebssystem der Schweißpresse mit Sonotrode 1 sind über einen elektrisch programmierbaren Motorantrieb die Absenkgeschwindigkeit mit ihren separaten Teilgrößen "Zustellbewegung" und "Arbeitsgeschwindigkeit" steuer- bzw. regelbar. Über ein Wegmeßsystem wird in bekannter Weise die Verformung über die vorgegebene Schweißzeit vorgewählt. Es können Wegbegrenzungen für eine konstante Restdicke des Drahtes 6 vorgegeben sein. Insbesondere wird nunmehr die Absenkgeschwindigkeit der Sonotrode 1 gezielt vorgegeben bzw. als Profil gesteuert. Damit kann die Prozeßzeit und die Qualität der Schweißverbindung optimiert werden.

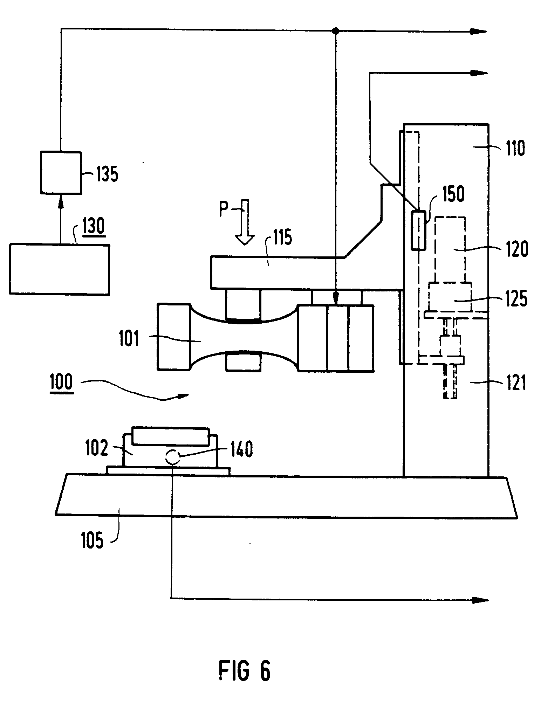

Bei einer Schweißpresse 100 gemäß FIG 6 ist eine Ultraschall-Sonotrode 101 als aktives Schweißwerkzeug am verschiebbaren Schlitten 115 eines Ständers 110 angebracht. Der Ständer 110 steht auf einer Grundplatte 105 mit einem Amboß 102 als Aufnahmewerkzeug für die Fügeteile. Im Ständer 110 ist ein Drehstrommotor 120 mit Getriebe 121 angeordnet, mit dem die Motorbewegung auf den Schlitten 115 übertragen wird. Die Drehbewegung des Motors 120 bzw. die dadurch erzielte Absenkbewegung der Sonotrode 101 kann mit einem Tachogenerator 125 vorgegeben werden.

Der Sonotrode 101 mit Ultraschall-Wandler ist ein Generator 130 mit nachgeschaltetem Steuergerät 135 zugeordnet, mit dem gleichermaßen die Ultraschallaktivierung der Sonotrode und der Motorantrieb gesteuert wird.

Die Schweißpresse 100 kann weiterhin einen Kraftaufnehmer 140 aufweisen, der vorteilhafterweise im Amboß 102 angeordnet ist. Gegebenenfalls kann damit die sich in den Fügeteilen aufbauende Kraft erfaßt werden. Zusätzlich kann auch ein Wegmeßsystem 150 vorhanden sein, mit dem der tatsächliche Verformungsweg der Fügeteile ermittelt wird.

Über eine Programmierung des Steuergerätes 135 können die Ultraschallaktivierung und die Absenkgeschwindigkeit der Sonotrode 101 hinsichtlich Beginn und Ende eingestellt werden. Insbesondere die Absenkgeschwindigkeit der Sonotrode kann dabei auch als veränderliches Zeitprofil vorgegeben werden. Dieses Zeitprofil wird so eingestellt, daß ein gewünschter Kraftverlauf realisiert wird. Dazu wird die Absenkgeschwindigkeit der Sonotrode beginnend mit der Berührung der Werkstücke zunächst klein gehalten und erst bei Plastifizierung der Werkstücke erhöht.

In FIG 7 bis FIG 9 sind die Prozeßparameter Ultraschall und Geschwindigkeit beim erfindungsgemäßen Verfahren mit elektrisch gesteuertem Pressenantrieb als Funktion der Zeit dargestellt. Der Graph 200 kennzeichnet die Absenkgeschwindigkeit der Sonotrode über einen kompletten Schweißzyklus, der sich in einzelne signifikante Bereiche einteilen läßt.

Im Bereich 11 verläuft die Bewegung der Sonotrode 101 mit einer freien Geschwindigkeit von beispielsweise 50 mm/s. Vom Punkt A ab wird die Absenkgeschwindigkeit wesentlich gedämpft und läuft im Bereich 12 mit geringer Geschwindigkeit. Am Punkt B wird der Ultraschall aktiviert, so daß beim Punkt C mit dem Auftreffen der Sonotrode auf die Oberfläche des Drahtes ein Kraftanstieg erfolgt, da die Werkstücke noch kalt sind.

Gemäß FIG 7 wird in verschiedenen Varianten die Absenkgeschwindigkeit der Sonotrode entsprechend den Linien 201 bis 204 konstant vorgewählt. Dabei wird der Wert der Geschwindigkeit in Abhängigkeit von den Abmessungen und/oder der Oberflächenbeschaffenheit der Werkstücke bestimmt. Insbesondere kann somit auch einer Beschichtung der Werkstücke Rechnung getragen werden.

Ein Kupferdraht mit einem Durchmesser <100 µm wird beispielsweise mit der geringsten Absenkgeschwindigkeit 201 der Sonotrode 101 verschweißt werden. Für dickere Drähte, bei denen das Verformungsvolumen zunimmt, kann die Absenkgeschwindigkeit erhöht werden, was aufgrund des Motorantriebs für die Schweißpresse in einfacher Weise möglich ist.

In FIG 8 wird die Absenkgeschwindigkeit der Sonotrode 101 gemäß der Linie 205 zunächst für einen längeren Zeitraum bei aktivierter Sonotrode gering gewählt. Damit ist Zeit vorgegeben, die die Drahtoberfläche vom Lack zu befreien bzw. auch Oxide und andere Verunreinigungen zu entfernen. Erst nach dem an der Fügefläche sämtliche nichtmetallischen Bestandteile entfernt sind, wird die Arbeitsgeschwindigkeit stufenweise erhöht und nunmehr ein vorgegebenes Verformungsprogramm durchfahren. Dabei verändert sich der Querschnitt des Drahtes in erwünschter Weise und durch den Ultraschall aktivierten Reibvorgang der Fügeteile entsteht die Schweißverbindung gemäß den Figuren 4 und 5. Nach Abschalten des Ultraschalls wird dann die Sonotrode 101 zurückgefahren.

Eine Veränderung der Absenkgeschwindigkeit von niedrigen zu höheren Werten kann statt stufenweise auch kontinuierlich erfolgen. In FIG 9 wird die Absenkgeschwindigkeit der Sonotrode gemäß der Linie 206 nach Art eines e-Profils verändert. Auch andere funktionale Abhängigkeiten sind möglich.

Es hat sich gezeigt, daß beim erfindungsgemäßen Verfahren die Prozeßzeit insgesamt verringert wird. Es braucht nicht mit separatem Vorimpuls und Hauptimpuls der Ultraschalleinwirkung gearbeitet zu werden, sondern lediglich mit einer durchgehenden Ultraschallaktivierung. Als Prozeßvariable wird im wesentlichen nur die Absenkgeschwindigkeit der Sonotrode verändert, wobei die über die Schweißzeit erfolgte Verformung vorgegeben werden kann.

## Patentansprüche

1. Verfahren zum Anschweißen von lackisolierten Drähten (6) und/oder Litzen auf metallische Träger (5) durch Ultraschall, bei dem durch Kraftbeaufschlagung einerseits und Ultraschalleinwirkung einer Sonotrode (1/101) andererseits eine stoffschlüssige Verbindung durch über die Schweißzeit vorgegebene Materialverformung (6', 6'') wenigstens der Drähte (6) und/oder Litzen entsprechend einer vorbestimmbaren Absenkgeschwindigkeit (v) der Sonotrode (1/101) erreicht wird, wobei die Absenkgeschwindigkeit (v) regel- oder programmierbar ist, **dadurch gekennzeichnet,** daß die Parameter für die Einstellung bzw. Regelung der Absenkgeschwindigkeit (v) der Sonotrode (1/101) die Abmessungen und/oder die Ausbildung der Oberflächen der Drähte (6) und/oder der Litzen bzw. deren Beschichtung (7) sind, wobei die Absenkgeschwindigkeit (v) während der Materialverformung entweder konstant (201-204) vorgegeben ist oder deren Änderung (205, 206) von niedrigeren zu höheren Werten vorprogrammiert wird.

2. Verfahren nach Anspruch 1, **dadurch gekennzeichnet,** daß die Absenkgeschwindigkeit (v) der Sonotrode stufenweise (205) erhöht wird (Figur 8).

3. Verfahren nach Anspruch 1, **dadurch gekennzeichnet,** daß die Absenkgeschwindigkeit (v) als Zeitprofil (206) vorgegeben wird (Figur 9).

4. Zur Durchführung des Verfahrens gemäß Anspruch 1 oder gemäß einem der Ansprüche 2 oder 3 vorgesehene Vorrichtung, mit einem Antriebssystem einer Ultraschall-Schweißpresse (100), die aus einer von einem Generator (130) aktivierbaren, absenkbaren Sonotrode (101) und einem feststehenden Amboß (102) zur Aufnahme des metallischen Trägers (5) besteht, wobei das Antriebssystem ein regel- oder programmierbarer Motorantrieb (120) ist**, dadurch gekennzeichnet,** daß dem Generator (130) für die Sonotrode (101) ein Steuergerät (135) nachgeschaltet ist, mit dem gleichermaßen die zeitliche Ultraschallaktivierung der Sonotrode (101) und die Regelung bzw. Programmierung des Motorantriebes (120) erfolgt, und daß Mittel zur Einstellung bzw. Regelung der Absenkgeschwindigkeit (v) der Sonotrode (1/101) entsprechend den Abmessungen und/oder der Ausbildung der Oberflächen der Drähten (6) und/oder der Litzen bzw. deren Beschichtung (7) vorhanden sind, welche Mittel die Absenkgeschwindigkeit (v) entweder konstant (201 bis 204) vorgeben oder deren Änderung (205, 206) von niedrigeren zu höheren Werten vorprgrammieren.

5. Vorrichtung nach Anspruch 4, **dadurch gekennzeichnet,** daß der programmierbare Motorantrieb (120) aus einem Drehstrommotor (121) mit Tachogenerator (125) besteht.

6. Vorrichtung nach Anspruch 4, **dadurch gekennzeichnet,** daß die Schweißpresse (100) einen Wegaufnehmer (150) enthält.

7. Vorrichtung nach Anspruch 4, **dadurch gekennzeichnet,** daß die Schweißpresse (100) einen Kraftsensor (140) enthält.

## Claims

1. Method for welding enamel-insulated wires (6) and/or litz wires onto metallic carriers (5) by means of ultrasound, by which by applying force, on the one hand, and ultrasonic action of a sonotrode (1/101), on the other hand, a material-closed connection is attained by means of material deformation (6',6''), which is preset over the welding time, of at least the wires (6) and/or litz wires in accordance with a predeterminable lowering speed (v) of the sonotrode (1/101), with it being possible to control or program the lowering speed (v), characterised in that the parameters for the adjustment or control of the lowering speed (v) of the sonotrode (1/101) are the dimensions and/or the formation of the surfaces of the wires (6) and/or the litz wires or their coating (7), in which case the lowering speed (v) during the material deformation is either preset so as to be constant (201-204) or its change (205, 206) from comparatively low values to comparatively high values is pre-programmed.

2. Method according to claim 1, characterised in that the lowering speed (v) of the sonotrode is increased stepwise (205) (Figure 8).

3. Method according to claim 1, characterised in that the lowering speed (v) is preset as a time profile (206) (Figure 9).

4. Arrangement provided for carrying out the method according to claim 1 or according to one of the claims 2 or 3, having a drive system of an ultrasonic welding press (100) which consists of a lowerable sonotrode (101), which can be activated by a generator (130), and a fixed anvil (102) for the accommodation of the metallic carrier (5), in which case the drive system is a controllable or programmable motor drive (120), characterised in that subsequently connected to the generator (130) for the sonotrode (101) there is a control unit (135) with which the ultrasonic activation of the sonotrode (101) within a given time and the control or programming of the motor drive (120) are effected in like manner and in that means are provided for adjusting or controlling the lowering speed (v) of the sonotrode (1/101) in accordance with the dimensions and/or the formation of the surfaces of the wires (6) and/or the litz wires or their coating (7), which means either preset the lowering speed (v) so that it is constant (201 to 204) or pre-program its change (205, 206) from comparatively low to comparatively high values.

5. Arrangement according to claim 4, characterised in that the programmable motor drive (120) consists of a three-phase motor (121) with tacho-generator (125).

6. Arrangement according to claim 4, characterised in that the welding press (100) contains a displacement sensor (150).

7. Arrangement according to claim 4, characterised in that the welding press (100) contains a force sensor (140).

## Revendications

1. Procédé pour souder des fils métalliques (6) et/ou des torons isolés par du vernis sur des supports (5) métalliques par ultrasons, dans lequel, par application d'une force d'une part, et par action des ultrasons d'une sonotrode (1/101) d'autre part, il est obtenu une liaison de matière à matière par déformation (6', 6'') de la matière d'au moins les fils (6) et/ou les torons, qui est donnée par la durée de soudage, en fonction d'une vitesse (v), qui peut être prescrite, d'abaissement de la sonotrode (1/101), la vitesse (v) d'abaissement étant réglable ou programmable, caractérisé en ce que les paramètres de réglage ou de régulation de la vitesse (v) d'abaissement de la sonotrode (1/101) sont les dimensions et/ou la constitution des surfaces des fils (6) et/ou des torons ou de leur revêtement (7), la vitesse (v) d'abaissement étant réglée à une valeur constante pendant la déformation de la matière où sa variation (205, 206) de valeurs petites à des valeurs grandes étant préprogrammée.

2. Procédé suivant la revendication 1, caractérisé en ce que la vitesse (v) d'abaissement de la sonotrode est augmentée par paliers (205) (figure 8).

3. Procédé suivant la revendication 1, caractérisé en ce que la vitesse (v) d'abaissement est donnée sous la forme d'un profil (206) en fonction du temps (figure 9).

4. Dispositif pour la mise en oeuvre du procédé suivant la revendication 1 ou l'une des revendications 2 ou 3, comprenant un système d'entraînement d'une presse (100) de soudage à ultrasons, qui se compose d'une sonotrode (101) susceptible d'être mise en action par un générateur (130) et d'être abaissée, et d'une enclume (102) fixe de réception du support (5) métallique, le système d'entraînement étant un dispositif d'entraînement (120) à moteur, réglable ou programmable, caractérisé en ce qu'en aval du générateur (130) de la sonotrode (101) est monté un appareil (135) de commande, par lequel est effectué de la même façon la mise en action des ultrasons de la sonotrode (101) en fonction du temps et la régulation ou la programmation du dispositif d'entraînement (120) à moteur, et en ce qu'il est prévu des moyens destinés à régler ou à réguler la vitesse (v) d'abaissement de la sonotrode (1/101) en fonction des dimensions et/ou de la constitution des surfaces des fils (6) et/ou des torons ou de leur revêtement (7), ces moyens donnant une vitesse (v) d'abaissement constante (201 à 204) ou préprogrammant sa variation (205, 206) de valeurs petites à des valeurs grandes.

5. Dispositif suivant la revendication 4, caractérisé en ce que le dispositif d'entraînement (120) à moteur programmable est constitué d'un moteur triphasé (121) à génératrice tachymétrique (125).

6. Dispositif suivant la revendication 4, caractérisé en ce que la presse (100) de soudage comporte un capteur de déplacement (150).

7. Dispositif suivant la revendication 4, caractérisé en ce que la presse (100) de soudage comporte un capteur de force (140).
